# EUROPEAN PATENT SPECIFICATION

(11) **EP 0 539 230 B1**
(45) Date of publication and mention of the grant of the patent: **14.04.1999**
(21) Application number: 92309753.9
(22) Date of filing: 23.10.1992
(51) Int. Cl.: H03K 19/0175

(54) **High speed, low power high common mode range voltage mode differential driver circuit**
Schnelle Differenztreiberstufer mit hoher Gleichtaktspannungsunterdrückung und geringem Leistungsverbrauch
Circuit d'attaque différentiel à grande vitesse, faible consommation et grande gamme de tension de mode commun

(30) Priority: 25.10.1991 US 782929
(43) Date of publication of application: 28.04.1993
(73) Proprietor: TEXAS INSTRUMENTS INCORPORATED, Dallas Texas 75265 (US)
(72) Inventor: Tomassetti, Steven R., Lewisville, Texas 75067 (US); Tsong, Danny, Taipei (TW)
(74) Representative: Nettleton, John Victor

(56) References cited:
- EP-A- 0 132 822
- DE-A- 3 941 840
- FR-A- 2 231 140
- PATENT ABSTRACTS OF JAPAN vol. 14, no. 288 (E-943)(4231) 21 June 1990 & JP-A-2 092113 ( NEC CORP. ) 30 March 1990
- PATENT ABSTRACTS OF JAPAN vol. 12, no. 449 (E-686)(3296) 25 November 1988 & JP-A-63 176015 ( MITSUBISHI ELECTRIC CORP. )

## Description

### FIELD OF THE INVENTION

This invention relates in general to transceivers, and, in particular to driver circuits for transceivers.

### BACKGROUND OF THE INVENTION

This application is related to U.S. patent application serial no. 07/782,706 (TI-16714) filed October 25, 1991.

A transceiver is an electrical device for sending and receiving electrical signals, in particular signals representative of data in a digital format. A transceiver is disposed at the interface between one system or device and a transmission line coupled to another system or device. For example, transceiver is used at the output of a computer to transmit the computer output over a wire to a peripheral device, such as a video display terminal or a printer. Many systems that have a central processing unit or microprocessor or microcomputer use transceivers. Such systems may be computers, telephone systems, disk drives, automotive control systems and other industrial systems. The transmission line connectible to the transceiver may be a ribbon, coaxial cable or a twisted pair of wires. The latter transmission line is typically coupled to a transceiver that conforms to the RS 485 interface standard.

A transceiver comprises two parts, a driver and a receiver. The driver has an input coupled to the output of a system, typically at the serial output of a UART (universal asynchronous receiver transmitter) device. The UART device converts the normal parallel data bits on a computer bus to a stream of serial bits. That serial stream of bits forms the input signal to the driver circuit of a transceiver. The driver circuit converts the logic level signal of the input to a level compatible with the transmission line. For example, the driver may convert a TTL, ECL or CMOS logic level signal to an RS 485 signal having a differential voltage equal to or greater than 1.5 volts and capable of driving a 54 ohm load.

Prior art driver circuits have been integrated onto a single semiconductor substrate using only bipolar transistors. Such devices have high speed and high drive capability but also consume large amounts of power even when no signal is being driven. Bipolar transistor circuits usually have bias current sources that power the bipolar transistors even when no signal is being driven. In addition, the number of transceivers that could be integrated onto a single semiconductor substrate has been limited by the power consumption of the bipolar transistors. At present, no more than four RS485 type transceivers can be integrated onto a single substrate, but it is desirable to increase the density of integration by adding more, high drive, high speed bipolar drive circuits to the transceiver substrate.

One solution to the power consumption problem has been to use only CMOS transistors in the driver circuit. However, pure CMOS circuits have several limitations. One is component breakdown voltage. CMOS devices simply cannot handle the voltage ranges of input signals to achieve an acceptable range of common mode operation. Common mode operation is a measure of driver performance.

Accordingly, there exists a long felt need for a transceiver with a driver having low power consumption in its quiescent state, a high common mode operation, and high speed.

DE-A-3 941 840 discloses a FET-TTL interface circuit comprising a first npn bipolar transistor arranged between a first potential and an output of the circuit, and a second npn bipolar transistor connected between the output and a second potential (ground). A first p-channel MOSFET has its source connected to the first potential, its drain connected to the base of the first bipolar transistor and its gate connected to an input of the circuit. A second n-channel MOSFET has its drain connected to the base of the first bipolar transistor, its source connected to the base of the second bipolar transistor, and its gate connected to the input of the circuit. A third n-channel MOSFET has its drain connected to the first potential, its source connected to the base of the second bipolar transistor, and its gate connected to the input of the circuit. A fourth n-channel MOSFET has its drain connected to the base of the second bipolar transistor, its source connected to the second potential, and its gate connected to the output of the circuit. A fifth n-channel MOSFET has its drain electrode connected to the output of the circuit, its source connected to the basis of the second bipolar transistor, and its gate connected to the input of the circuit.

The document PATENT ABSTRACTS OF JAPAN, Vol. 14, No. 288, (E-943) [4231] for JP-A-2 092 113 discloses a circuit in which a p-type MOS transistor has its source-drain path connected in series with the source-drain path of an n-type MOS transistor. One end of the series-connected MOS transistors is connected to V_{DD} and the other end is connected to ground. Two bipolar transistors likewise have their collector-emitter paths connected in series from V_{DD} to ground. The junction of the series-connected bipolar transistors is connected to an output terminal. A further n-type MOS transistor has its source-drain path connected from the output terminal to the base of the bipolar transistor that is connected to ground. An input terminal is connected to the gates of all three MOS transistors. The circuit speeds up operation by discharging the charge accumulated in the base of a first one of the bipolar transistors changing from ON to OFF into the base of the other bipolar transistor changing from OFF to ON.

The document PATENT ABSTRACTS OF JAPAN, Vol. 12, No. 449, (E-686) [3296] for JP-A-63 176 015 discloses a circuit to prevent a harmful current from flowing into an integrated circuit from a common bus connected with an output terminal. A switching circuit, interposed between a first power supply and a first MOS transistor, is turned on/off in "interlocking" relationship with the on/off state of the first power supply.

In more detail, an npn transistor as switching element is interposed between a power terminal and a p-type MOS transistor. The emitter of the npn transistor is connected to the source of the p-type MOS transistor and the collector is connected, together with the base, to the power terminal. With power supply voltage turned off and the npn transistor turned off in "interlocking" relationship therewith, the current path between an output terminal and the power terminal is disconnected. It is stated that even when an "H" signal is supplied to the common bus connecting to the output terminal from another integrated circuit, no harmful current flows [from] the output terminal to the power terminal.

The present invention provides a driver circuit having an input node and an output node, comprising:
a first current source coupled to the input node and coupled to a voltage supply;
a first bipolar transistor having a base coupled to the current source, and being coupled to the voltage supply and the output node to deliver a first output current;
a second current source coupled to the output node and a second voltage supply;
a second bipolar transistor having a base coupled to the second current source and further coupled between the second voltage supply and the output node to deliver a second output current; **characterized in that:**
a first current limiting circuit for limiting the first output current is coupled to the first current source and the first bipolar transistor;
a second current limiting circuit for limiting the second output current is coupled to the second current source and the second bipolar transistor; and wherein
the first current limiting circuit comprises a third bipolar transistor having a base coupled to the base of the first bipolar transistor, an emitter coupled to the emitter of the first bipolar transistor and a collector coupled to the input node, the third bipolar transistor being scaled to the first bipolar transistor.

The embodiment of the invention illustrated in the accompanying drawings solves the problems of the prior art and meets the long felt need in the art by providing a transceiver with BiCMOS circuitry. The illustrated embodiment arranges the CMOS transistors to minimize power consumption in a quiescent state and the bipolar transistors to drive and switch the load.

In particular, the transceiver driver circuit has a pull up/pull down circuit with CMOS transistors supply base current to the bipolar pull up and pull down transistors. In its quiescent state the CMOS transistors draw no current so the power consumption of the circuit under no load conditions is minimized. The illustrated embodiment allows the integration of five or more transceivers with bipolar differential driver circuits on one substrate.

The driver circuit also includes a current mirror circuit. The current mirror circuit protects the driver from exceeding the drive current and voltage for the transmission line and the rated currents and voltages of the pull up/pull down transistors. The current mirror is coupled between the input and output of the pull up/pull down circuit. It measures the output current. If a predetermined output current is exceeded, the current mirror circuits turn off the current supply to the base of the bipolar transistor. The current mirror circuit comprises a pair of bipolar transistors sized to be a fraction of the size of the pull up/pull down transistors.

The driver circuit also has a speed up circuit. The speed up circuit comprises CMOS transistors coupled between ground and the base of the bipolar pull up/pull down transistors. The gates of the speed up bipolar transistors are coupled to the input of the driver. When the input driver signal goes low, the gates turn on to connect the appropriate base of the pull up or pull down transistor to ground and thereby speed up the shut off of the pull up or pull down transistor.

### BRIEF DESCRIPTION OF THE DRAWINGS

Fig 1. is a block diagram of a system using a transceiver.

Fig 2. is a block diagram of a differential driver for the transceiver of Fig. 1.

Fig 3. is an electrical schematic of half of the differential driver of Fig.2.

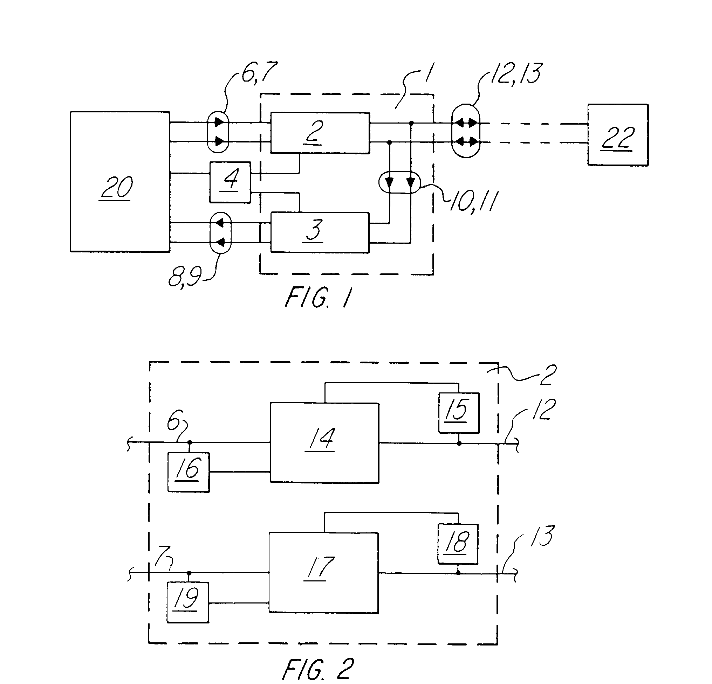

Turning to Figure 1, there is shown a first system 20, for example a computer having a transceiver 1 coupled to a pair of transmission lines 12, 13 which terminate at a peripheral device 22, such as a video display terminal or a printer. The transceiver 1 comprises a driver circuit 2 and a receiver circuit 3. In response to a signal, output from the computer 20 to a chip enable function pin 4, the transceiver 1 will enable either the driver 2 or the receiver 3. Information in the form of single-ended digital signals is output from the computer 20 typically over a large bus, including a number of lines such as lines 6 and 7. Line 6, for example, meets a single-ended signal which is converted by the driver circuit 2 to a signal level compatible with the requirements of transmission lines 12, 13. In the preferred embodiment, the transmission lines 12, 13 are designed to match a standard RS485 interface. The transmission lines are also coupled via lines 10 and 11 to receiver circuit 3. Chip enable pin 4 will couple the output of receiver 3 consisting of single-ended signals to computer 20 input via a line such as 8 or 9. Lines 8, 9 are generally also part of a large bus of computer 20. The system shown in Figure 1 has a single transceiver. Current levels of integration compatible with bipolar circuits allow for an integration of a maximum of four transceivers on a single semiconductor substrate. However, with the subject invention, it is possible to integrate five or more transceivers on a single substrate. So far, the invention has been successful in integrating as many as nine transceivers on a single substrate.

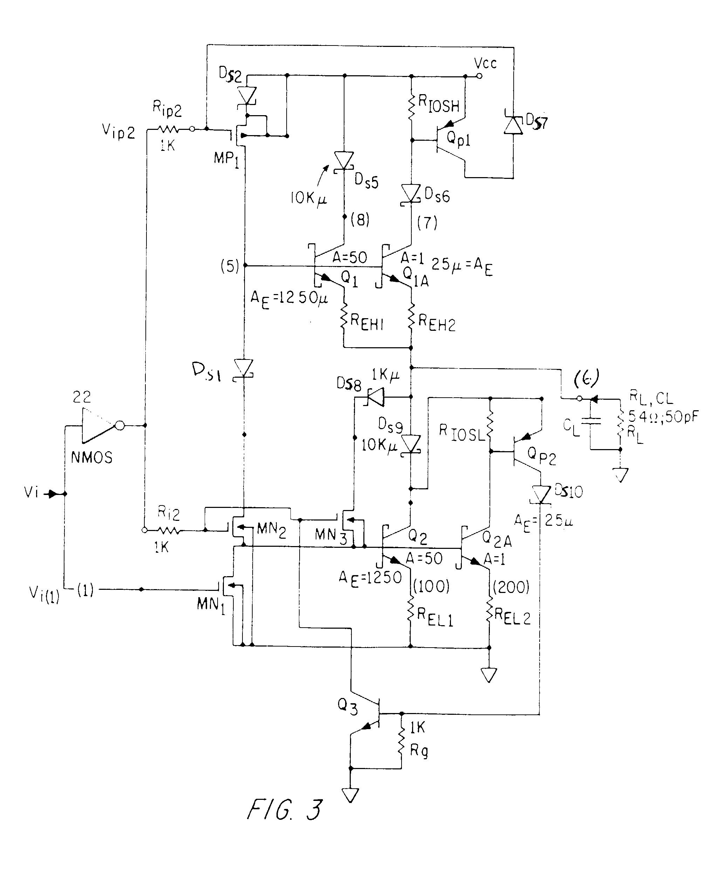

The driver circuit 2 is shown in further schematic detail in Figure 2. The input signal passes through a single-ended to differential signal transmitter such as is known in the art and is input respectively over lines 6 and 7 to pull up/pull down circuits 14, 17. Both of the pull up/pull down circuits 14, 17 comprise bipolar drive transistors with MOS current sources providing power to the bases of the drive transistors. The details of a typical driver circuit will be discussed further in connection with Figure 3. Pull up/pull down circuits 14, 17 each have an output circuit mirror circuit 15, 18, respectively coupled between the outputs of the pull up/pull down circuits and the circuits themselves. The current mirror circuits 15, 18 measure the output on transmission lines 12, 13. If the output exceeds a certain predetermined level, then the current mirrors terminate the input drive to the pull up/pull down circuits 14, 17. Pull up/pull down circuits 14, 17 also have speed up circuits 16, 19, respectively coupled thereto. The speed up circuits 16, 19 sense the input signal level on input lines 6,7. When the input signal falls to a predetermined level indicating no signal on lines 6,7, the speed up circuits 16, 19 assist in rapidly turning off the current sources that provide current for the pull up/pull down circuits.

Turning to Figure 3, there is shown a schematic diagram of one of the driver circuits 14, 17 of Figure 2. An input voltage Vi is provided to the gate of an NMOS transistor MN₁, and to the input of an inverter 22. The output of inverter 22 is connected to the gate of a p-channel transistor MP₁ through a resistor Rip2, and to the gate of an n-channel transistor MN₂ through resistor Ri2.

The drain of p-channel transistor MP₁ is connected to the bases of NPN transistors Q1 and Q_{1A} as well as to the anode of Schottky diode D_{S1}, The source of transistor MP₁ is connected to the cathode of Schottky diode D_{S2} the anode of which is connected to a supply voltage Vcc.

The collector of transistor Q1 is connected to Vcc through Schottky diode D_{S5}, while the collector of transistor Q_{1A} is connected to Vcc through resistor R_{IOSH} and Schottky diode D_{S6}. Resistor R_{IOSH} is also connected across the emitter and base of a PNP transistor Q_{P1}, which has its emitter connected to Vcc. The emitter of transistor Q_{P1} is connected to the gate of transistor MP₁ through a Schottky diode D_{S7}.

The emitters of transistors Q1 and Q_{1A} are connected to node 6 through resistors R_{EH1} and R_{EH2}, respectively.

The gate of transistor mn2 is connected to the gate of an n-channel transistor MN₃ and to the collector of an NPN transistor Q3. The source of transistor MN₂ is connected to the drain of transistor MN₁ and to the bases of NPN transistors Q2 and Q_{2A}, as well as to the source of transistor MN₃. The drain of transistor MN₃ is connected to node 6 through Schottky diode D_{S8}.

The collector of transistor Q2 is connected to node 6 through Schottky diode D_{S9}, well as to one end of resistor R_{IOSH}, which has its other end connected to the base of a PNP transistor Q_{P2}, and to the emitter of transistor Q_{P2}. The collector of transistor Q2_{A} is connected to the base of transistor Q_{P2}. The emitters of transistors Q2 and Q2_{A} are connected to ground through resistors R_{EL1} and R_{EL2}, respectively.

The collector of transistor Q_{P2} is connected to the base of transistor Q3. The base of Q3 is connected to ground through resistor Rg, while the emitter of Q3 is connected to ground, as is tiiu source of transistor MN₁.

The circuit shown in Figure 3 provides a push-pull drive to one end of a differential transmission line, shown as R_{L} and C_{L} node 6.

A logic input signal Vi is provided at the input of the driver circuit 14 or 17. A complementary signal Vip2 is generated with the use of inverter 22, preferably a simple CMOS inverter. When Vi is high, Vip2 goes low, turning on transistor MP₁, which provides base drive current for the pull up stage output transistor Q1, which provides drive current to the load.

At the same time, since Vip2 is low, transistor MN₂ is turned off, so as not to drain current from drive transistor Q1. NN₃ is also simultaneously turned off to prevent current drain from node 6.

Q1a, Qp1, R_{IOSH} and Rip2 form a current limiting circuit, which is a requirement of RS485. Q1 and Q_{1A} are matched as scaled to each other such that the collector current of Q_{1A} is a multiple of the collector current of Q1. In the preferred embodiment, the scaling factor is fifty to one. As the output impedance drops (going toward a short circuit condition on the output), there is a voltage drop across the base-emitter junction of QP₁. As it goes up and reaches forward bias voltage, QP₁ delivers collector current back to the gate of MP₁, generating a voltage drop across Rip2, turning MP₁ off. R_{IOSH} is chosen so that at the appropriate Q_{1A} collector current, QP₁ is turned on. The scaling factor between Q1 and Q_{1A} is chosen such that the value of R_{IOSH} can be reasonable, and thus easily manufacturable.

When Vi is high, it also is provided to the gate of MN₁, turning it on, which provides a low impedance path from the bases of sink transistors Q2 and Q_{2A}, helping turn them off.

When Vi is low, inverter 22 provides a high signal to PMOS transistor MP₁, turning it off, which then removes the drive current from sourcing transistors Q1 and Q1a. At the same time, the high signal is provided to the gate of MN₂ and to MN₃. The source of MN₂ is thus tied to base of Q2, while its drain is connected to the bases of Q1 and Q_{1A} through D_{S2}. This provides a discharge path for its stored base charge, which provides for a quick turn off, allowing the circuit to operate with zero quiescent current under no load conditions. It also provides a brief surge of current which is used to help turn Q2 on.

Simultaneously, MN₃ is also turned on, tied from the output node 6 to the bases of drain transistors Q2 and Q_{2A}. Thus, the base drive current for sink transistors Q2 and Q_{2A} actually comes from the load, which is an advantage. The base drive, which would normally account for 10-15% of the power required, would conventionally come from the power supply. This configuration allows minimum power dissipation.

The sink transistors have the same ratio that the drive transistors Q1 and Q_{1A} have. The current through Q_{2A} is monitored in a similar manner to the current through Q1A, Q2A, Qp2, R_{IOSL} and R₁₂ form the current limiting circuit for the sink transistors Q2 and Q2A. When the voltage drop across R_{IOSL} reaches one Vbe, transistor. QP₂ turns on, which provides base current to Q3, turning Q3 on, which in turn sinks the drive signal to the gate of MN₂ and MN₃, turning them off, which removes the drive current from the bases of Q2 and Q2A, turning them off.

Schottky blocking diodes are used with high voltage MOS and bipolar components to allow extended output common mode range above Vcc and below ground, as required by RS485. For the pull-up stage, D_{S2} blocks the current path through the drain-backgate diode of MP₁ when the output is pulled above Vcc. Ds5 and Ds6 provide similar blocking under the same conditions for the base collector diodes of Q1 and Q1A.

For the pull down stage, Ds7 provides blocking for the current path formed by the base-collector diodes of Q2 and Q2A.

Although the invention has been described and illustrated with a certain degree of particularity, is understood that the present disclosure has been made by way of example only and that numerous changes in the combination and arrangement of parts or steps may be resorted to by those skilled in the art without departing from the scope of the invention as defined in the appended claims.

## Claims

1. A driver circuit having an input node and an output node, comprising:
a first current source (MP₁) coupled to the input node and coupled to a voltage supply (Vcc);
a first bipolar transistor (Q₁) having a base coupled to the current source (MP₁), and being coupled to the voltage supply (Vcc) and the output node to deliver a first output current;
a second current source (MN₂) coupled to the output node and a second voltage supply;
a second bipolar transistor (Q₂) having a base coupled to the second current source (MN₂) and further coupled between the second voltage supply and the output node to deliver a second output current; **characterized in that:**
a first current limiting circuit (Q_{1A}, Qₚ₁, R_{IOSH}, Rᵢₚ₂) for limiting the first output current is coupled to the first current source (MP₁) and the first bipolar transistor (Q₁);
a second current limiting circuit (Q_{2A}, Qₚ₂, R_{IOSL}, Rᵢ₂) for limiting the second output current is coupled to the second current source (MN₂) and the second bipolar transistor (Q₂); and wherein
the first current limiting circuit comprises a third bipolar transistor (Q_{1A}) having a base coupled to the base of the first bipolar transistor (Q₁), an emitter coupled to the emitter of the first bipolar transistor (Q₁) and a collector coupled to the input node, the third bipolar transistor (Q_{1A}) being scaled to the first bipolar transistor (Q₁).

2. The driver circuit of claim 1, wherein the second current limiting circuit comprises:
a fourth bipolar transistor (Q_{2A}) having a base coupled to the base of the second bipolar transistor , an emitter coupled to the emitter of the second bipolar transistor (Q₂), and a collector coupled to the collector of the second bipolar transistor (Q₂).

3. The driver circuit of claim 2, wherein the fourth bipolar transistor (Q_{2A}) is scaled to the second bipolar transistor (Q₂).

4. The driver circuit of any preceding claim, wherein the first current limiting circuit further comprises:
a fifth bipolar transistor (Qₚ₁) having a base coupled to the collector of the third bipolar transistor (Q_{1A}), and a current path coupled between the first voltage supply (Vcc) and the input of the first current source (MP₁).

5. The driver circuit of any preceding claim, wherein the second current limiting circuit further comprises a sixth bipolar transistor (Qp₂) having a base coupled to the collector of the fourth bipolar transistor (Q_{2A}), and a current path coupled between the collector of the fourth bipolar transistor (Qp₂) and the input of the second current source (MN₂).

6. The driver circuit of any preceding claim, wherein the first and second current sources comprise a pair of CMOS transistors (MP₁, MN₂).

7. The driver circuit of any preceding claim, wherein the second current source (MN₂) is off when the first current source (MP₁) is on.

8. The driver circuit of any preceding claim, wherein the first current source (MP₁) is off when the second current source (MN₂) is on.

## Patentansprüche

1. Treiberschaltung mit einem Eingangsschaltungspunkt und einem Ausgangsschaltungspunkt, mit:
einer ersten Stromquelle (MP₁), die mit dem Eingangsschaltungspunkt verbunden und an eine Versorgungsspannung (Vcc) gelegt ist;
einem ersten bipolaren Transistor (Q₁), der eine mit der Stromquelle (MP₁) verbundene Basis aufweist und mit der Versorgungsspannung (Vcc) sowie zur Abgabe eines ersten Ausgangsstroms mit dem Ausgangsschaltungspunkt verbunden ist;
einer zweiten Stromquelle (MN₂), die mit dem Ausgangsschaltungspunkt verbunden und an eine zweite Versorgungsspannung gelegt ist;
einem zweiten bipolaren Transistor (Q₂), der eine mit der zweiten Stromquelle (MN₂) verbundene Basis aufweist und außerdem zwischen der zweiten Versorgungsspannung und dem Ausgangsschaltungspunkt zur Abgabe eines zweiten Ausgangsstroms angeschlossen ist;
dadurch gekennzeichnet, daß:
eine erste Strombegrenzungsschaltung (Q_{1A}, Qₚ₁, R_{IOSH}, Rᵢₚ₂) zum Begrenzen des ersten Ausgangsstroms mit der ersten Stromquelle (MP₁) und dem ersten bipolaren Transistor (Q₁) verbunden ist;
eine zweite Strombegrenzungsschaltung (Q_{2A}, Qₚ₂, R_{IOSL}, Rᵢ₂) zum Begrenzen des zweiten Ausgangsstroms mit der zweiten Stromquelle (MN₂) und dem zweiten bipolaren Transistor (Q₂) verbunden ist; wobei
die erste Strombegrenzungsschaltung einen dritten bipolaren Transistor (Q_{1A}) enthält, der eine mit der Basis des ersten bipolaren Transistors (Q₁) verbundene Basis, einen mit dem Emitter des ersten bipolaren Transistors (Q₁) verbundenen Emitter und einen mit den Eingangsschaltungspunkten verbundenen Kollektor aufweist, wobei der dritte bipolare Transistor (Q_{1A}) in bezug auf den ersten bipolaren Transistor (Q₁) skaliert ist.

2. Treiberschaltung nach Anspruch 1, bei welcher die zweite Strombegrenzungsschaltung enthält:
einen vierten bipolaren Transistor (Q_{2A}) mit einer Basis, die mit der Basis des zweiten bipolaren Transistors verbunden ist, einem Emitter, der mit dem Emitter des zweiten bipolaren Transistors (Q₂) verbunden ist und einem Kollektor, der mit dem Kollektor des zweiten bipolaren Transistors (Q₂) verbunden ist.

3. Treiberschaltung nach Anspruch 2, bei welcher der vierte bipolare Transistor (Q_{2A}) bezüglich des zweiten bipolaren Transistors (Q₂) skaliert ist.

4. Treiberschaltung nach einem der vorhergehenden Ansprüche, bei welcher die erste Strombegrenzungsschaltung ferner enthält:
einen fünften bipolaren Transistor (Qₚ₁) mit einer Basis, die mit dem Kollektor des dritten bipolaren Transistors (Q_{1A}) verbunden ist, sowie mit einem Stromweg zwischen der ersten Versorgungsspannung (Vcc) und dem Eingang der ersten Stromquelle (MP₁).

5. Treiberschaltung nach einem der vorhergehenden Ansprüche, bei welcher die zweite Strombegrenzungsschaltung ferner einen sechsten bipolaren Transistor (Q_{P2}) enthält, der eine mit dem Kollektor des vierten bipolaren Transistors (Q_{2A}) verbundene Basis sowie einen Stromweg zwischen dem Kollektor des vierten bipolaren Transistors (Q_{P2}) und dem Eingang der zweiten Stromquelle (MN₂) aufweist.

6. Treiberschaltung nach einem der vorhergehenden Ansprüche, bei welcher die erste und die zweite Stromquelle zwei CMOS-Transistoren (MP₁, MN₂) enthalten.

7. Treiberschaltung nach einem der vorhergehenden Ansprüche, bei welcher die zweite Stromquelle (MN₂) abgeschaltet ist, wenn die erste Stromquelle (MP₁) eingeschaltet ist.

8. Treiberschaltung nach einem der vorhergehenden Ansprüche, bei welcher die erste Stromquelle ((MP₁) abgeschaltet ist, wenn die zweite Stromquelle (MN₂) eingeschaltet ist.

## Revendications

1. Circuit d'attaque ayant un noeud d'entrée et un noeud de sortie, comprenant :
une première source de courant (MP₁) couplée au noeud d'entrée et couplée à une source d'alimentation en tension (Vcc) ;
un premier transistor bipolaire (Q₁) ayant une base couplée à la source de courant (MP₁), et étant couplée à la source d'alimentation en tension (Vcc) et au noeud de sortie pour délivrer un premier courant de sortie ;
une deuxième source de courant (MN₂) couplée au noeud de sortie et à une deuxième source d'alimentation en tension ;
un deuxième transistor bipolaire (Q₂) ayant une base couplée à la deuxième source de courant (MN₂) et couplée en outre entre la deuxième source d'alimentation en tension et le noeud de sortie pour délivrer un deuxième courant de sortie, caractérisé en ce que :
un premier circuit limiteur de courant (Q_{1A}, Q_{P1}, R_{IOSH}, R_{iP2}) pour limiter le premier courant de sortie est couplé à la première source de courant (MP₁) et au premier transistor bipolaire (Q₁) ;
un deuxième circuit limiteur de courant (Q_{2A}, Q_{P2}, R_{IOSL}, Rᵢ₂) pour limiter le deuxième courant de sortie est couplé à la deuxième source de courant (MN₂) et au deuxième transistor bipolaire (Q₂) ; et dans lequel
le premier circuit limiteur de courant comporte un troisième transistor bipolaire (Q_{1A}) ayant une base couplée à la base du premier transistor bipolaire (Q₁), un émetteur couplé à l'émetteur du premier transistor bipolaire (Q₁) et un collecteur couplé au noeud d'entrée ; le troisième transistor bipolaire (Q_{1A}) étant dimensionné par rapport au premier transistor bipolaire (Q₁).

2. Circuit d'attaque selon la revendication 1, dans lequel le deuxième circuit limiteur de courant comporte :
un quatrième transistor bipolaire (Q_{2A}) ayant une base couplée à la base du deuxième transistor bipolaire, un émetteur couplé à l'émetteur du deuxième transistor bipolaire (Q₂), et un collecteur couplé au collecteur du deuxième transistor bipolaire (Q₂).

3. Circuit d'attaque selon la revendication 2, dans lequel le quatrième transistor bipolaire (Q_{2A}) est dimensionné par rapport au deuxième transistor bipolaire (Q₂).

4. Circuit d'attaque selon l'une quelconque des revendications précédentes, dans lequel le premier circuit limiteur de courant comporte en outre :
un cinquième transistor bipolaire (Q_{P1}) ayant une base couplée au collecteur du troisième transistor bipolaire (Q_{1A}), et un trajet de courant couplé entre la première source d'alimentation en tension (Vcc) et l'entrée de la première source de courant (MP₁).

5. Circuit d'attaque selon l'une quelconque des revendications précédentes, dans lequel le deuxième circuit limiteur de courant comporte en outre un sixième transistor bipolaire (Q_{P2}) ayant une base couplée au collecteur du quatrième transistor bipolaire (Q_{2A}), et un trajet de courant couplé entre le collecteur du quatrième transistor bipolaire (Q_{P2}) et l'entrée de la deuxième source de courant (MN₂),

6. Circuit d'attaque selon l'une quelconque des revendications précédentes, dans lequel les première et deuxième sources de courant comportent une paire de transistors CMOS (MP₁, MN₂).

7. Circuit d'attaque selon l'une quelconque des revendications précédentes, dans lequel la deuxième source de courant (MN₂) est désactivée lorsque la première source de courant (MP₁) est activée.

8. Circuit d'attaque selon l'une quelconque des revendications précédentes, dans lequel la première source de courant (MP₁) est désactivée lorsque la deuxième source de courant (MN₂) est activée.
